**Europäisches Patentamt**

**European Patent Office**

**Office européen des brevets**

(19)

(11) **EP 1 195 867 A1**

(12) **EUROPEAN PATENT APPLICATION**

(43) Date of publication:
**10.04.2002 Bulletin 2002/15**

(51) Int Cl.$^7$: **H01S 5/40**

(21) Application number: **01305278.2**

(22) Date of filing: **18.06.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **04.09.2000 EP 00119118**

(71) Applicant: **LUCENT TECHNOLOGIES INC.**
**Murray Hill, New Jersey 07974-0636 (US)**

(72) Inventors:
• **Buchold, Bianca**
  **Nuremberg 90408 (DE)**

• **Werner, Dieter**
  **Neunkirchen am Brand 91077 (DE)**
• **Zankl, Dieter**
  **Nuremberg 90408 (DE)**

(74) Representative:
**Buckley, Christopher Simon Thirsk et al**
**Lucent Technologies NS UK Limited,**
**Intellectual Property Division,**
**5 Mornington Road**
**Woodford Green, Essex IG8 0TU (GB)**

(54) **Method for wavelenght stabilization of light emission from emission devices and arrangement therefor**

(57) The invention performs wavelength stabilization or wavelength fixing of the light emission from one and a plurality of emission devices by means of external optical resonator means. In the case of stabilization of the light emission of only one emission device, use is made of a wavelength-selective reflection unit together with a beam splitting unit as resonator means. In the case of a plurality of emission devices, the output spectra thereof are superposed to form an overall spectrum, the overall spectrum is reflected at a reflection unit, the reflected overall spectrum is separated into the output spectra, the reflected output spectra are fed to the respective emission devices and the reflected output spectra are re-emitted from the emission devices. The re-emitted reflected emission spectra are again mixed to form a modified overall spectrum and the modified overall spectrum is coupled out of the resonator. According to the invention, the reflection of the overall spectrum is in this case effected at a wavelength-independent reflection unit.

# FIG. 1

**Description**

The invention relates to a method for wavelength stabilization of optical emission devices in accordance with Claim 1 and arrangements in accordance with Claims 6 and 24.

In optical transmission systems, semiconductor lasers or semiconductor laser diodes are often used as emission devices. In this case, the laser diodes can also be used in an optical amplifier as so-called pump lasers. The use of Fabry-Perot lasers is particularly common here, these lasers emitting a relatively wide output spectra with a bandwidth of several nanometers. If these lasers are used in broadband amplifiers, in particular erbium-doped fibre amplifiers or Raman amplifiers, then the behaviour of the amplifier is especially dependent on the centre wavelength of the emission of the pump lasers.

However, a shift in the centre wavelength of the lasers used as a function of the temperature and/or of the injection current can often be observed in this case. In order to avoid disturbing influences connected with a shift in the centre wavelength of the lasers, the lasers are stabilized at a specific wavelength or fixedly coupled to a specific wavelength.

One way of achieving the coupling of the emission of an individual laser diode to a specific wavelength is to use a fibre Bragg grating adapted to the emission. Such a fibre Bragg grating generally has a reflectivity of about a few per cent in a narrow spectral range. In this case, the fibre Bragg gratings are used outside the laser diode as a reflection and coupling-out unit in such a way that an external resonator is produced. In this case, the standing wave field generated in the external resonator corresponds to the wavelength to which the output spectra of the laser is fixedly coupled or stabilized.

Using such fibre Bragg gratings, lasers can be stabilized sufficiently well for many applications. However, a disadvantage here is that such fibre Bragg gratings are very expensive and even difficult to obtain commercially. Thus, there is even a real bottleneck in the case of fibre Bragg gratings for specific wavelengths. Moreover, the Bragg grating has to be adapted in each case to the laser type, that is to say to its emission wavelength. Under certain circumstances, depending on the coherence length of the respective laser, the Bragg grating has to be externally fitted at a relatively large distance. That leads to a relatively large arrangement whose manipulability is thereby severely impaired.

In addition to the use in fibre amplifiers, wavelength-stabilized lasers are also used as so-called pump lasers in Raman amplifiers. In this case, it is necessary to achieve optical powers which exceed the magnitude of 100 mW by a multiple. In this case, it is then necessary for the emission wavelengths of a plurality of lasers to be simultaneously wavelength-stabilized. To that end, a plurality of fibre Bragg gratings are used, at great expense. These stabilized powers have to be fed into a fibre in which the Raman amplification is effected. To that end, the emissions of a plurality of pump lasers are fed into a fibre using a multiplexing method, with a further space requirement.

Consequently, the invention is based on the object of stabilizing the wavelength of an emission device or fixedly coupling the latter in each case to a specific wavelength, and at the same time avoiding the use of a Bragg grating. A further object of the invention is to stabilize emission spectra from emission devices with regard to the wavelength, without restricting the usability by an increased space requirement.

The features of Claims 1, 6 and 24 serve for achieving the object.

The invention entails the advantage that a plurality of lasers are fixedly coupled or stabilized at a wavelength and are simultaneously integrated in an optical device, which, in particular in the context of the progressive miniaturization in telecommunications technology and electronics, generally significantly and advantageously reduces the size of the laser unit.

Further advantages emerge from the subclaims.

The invention performs wavelength stabilization or wavelength fixing of the light emission of at least two emission devices by means of external optical resonator means. In this case, output spectra of the at least two emission devices are superposed to form an overall spectrum, the overall spectrum is reflected at a reflection unit, the reflected overall spectrum is separated into the output spectra, the reflected output spectra are fed to the respective emission devices and the reflected output spectra are re-emitted from the emission devices. The re-emitted reflected emission spectra are again mixed to form a modified overall spectrum and the modified overall spectrum is coupled out of the resonator. According to the invention, the reflection of the overall spectrum is in this case effected at a wavelength-independent reflection unit.

In the case of the method according to the invention, the overall spectrum is split into two components, of which the first component is reflected and the second component is transmitted. In this case, the first, reflected component is small, with regard to intensity, relative to the second transmitted component. The first, reflected component of the overall spectrum is built up in an optical mixing and demixing unit in accordance with the output spectra. In the mixing and demixing unit, the separation of the first, reflected component in accordance with the output spectra is effected selectively with regard to respective transmission maxima.

The invention's arrangement for wavelength stabilization of an emission spectrum emitted by only one emission device has at least one emission device and an optical resonator provided externally with respect to the at least one emission device, and also a beam splitting device and an output device for the emission spectrum. In this case, the beam splitting device is arranged in the beam path in such a way that the emission spectrum of the emission device traverses the beam splitting device at least twice. According to the invention, the resonator is delimited by a reflection unit outside the at least one emission device.

The reflection unit may reflect the emission spectrum wavelength-selectively and be provided in such a way that the emission spectrum reflected by it traverses the beam splitting device at least twice. The advantage resides in the fact that the emission spectrum of the external resonator is then stabilized in accordance with the wavelength selected by the reflection unit.

The invention also provides for the emission spectra emitted by a plurality of emission devices in an optical arrangement to be stabilized or fixed with regard to wavelength. To that end, the arrangement according to the invention then has an optical mixing and demixing unit which is arranged in the beam path in such a way that the emission spectra of the emission devices traverse each of the units at least twice. The resonator is then delimited by a wavelength-independent reflection unit outside the emission devices.

In a particularly preferred embodiment of the invention, the emission spectrum from a plurality of lasers, preferably semiconductor laser diodes, are fixed or coupled with regard to the wavelength and/or specific optical modes. This is done outside the laser diodes in an external resonator by combination of an optical multiplexer, which preferably operates by means of interference, for instance interferometrically or dispersively and a wavelength-independent reflection unit. Advantageously, the multiplexer, without an additional space requirement, is already used within the resonator for stabilizing the wavelengths and simultaneously allows the emissions of a plurality of lasers to be fed into a fibre. The emission wavelengths of the resonator are essentially determined by the emission wavelengths of the individual lasers and the transmission bands of the multiplexer which are adapted thereto. In this case, the intensity of the emission of the external resonator is to the greatest possible extent unaffected by spectral shifts, for instance thermally induced ones, or spectral drift phenomena of the optical elements used.

The invention provides for the wavelength-independent reflection unit also to be designed as an output device for the modified overall spectrum. This is preferably realized by a Fresnel reflection unit, for instance a glass/air junction. If the invention is used in a glass fibre environment, then the glass/air junction is advantageously provided as an interruption of an optical fibre.

In another embodiment, the reflection unit may be the end of a fibre on which a metal has been vapour-deposited.

The multiplexer may be embodied as a Mach-Zehnder interferometer and preferably be produced using fused technology from optical fibres.

It is also conceivable for the arrangement according to the invention to be designed as an integrated optical unit, which drastically reduces the size of the arrangement and increases the usability thereof.

The invention is explained in more detail below using two exemplary embodiments in connection with the accompanying drawings.

In the figures:

Fig. 1        shows a first embodiment of the invention;

Fig. 2        shows output spectra from emission devices according to the invention;

Fig. 3a      shows the spectral transmission characteristic of an optical multiplexer according to the invention;

Fig. 3b      shows the spectral emission of the overall spectrum emitted from an external resonator; and

Fig. 4        shows the realization of the invention with the aid of a junction at two optical materials having different refractive indices.

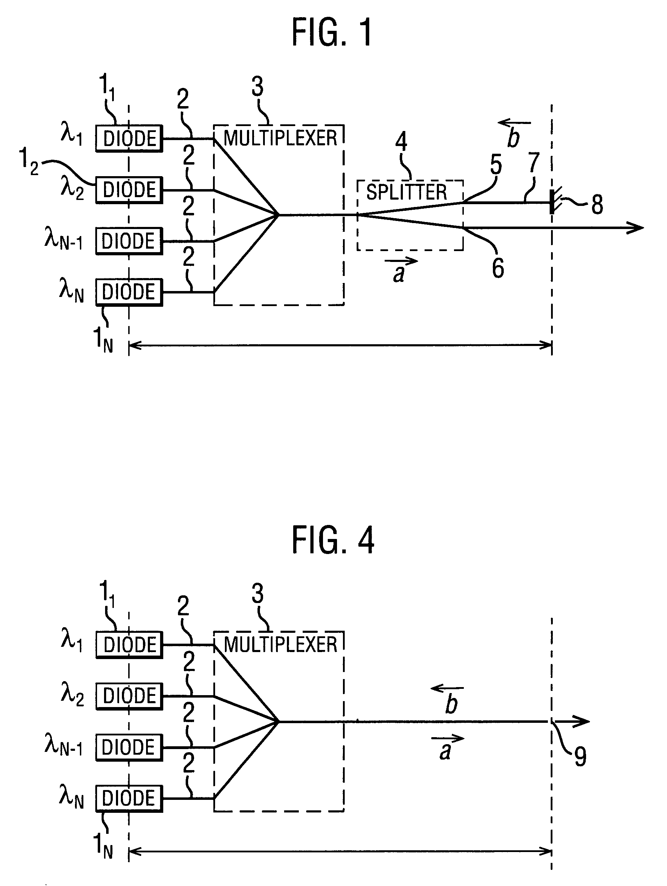

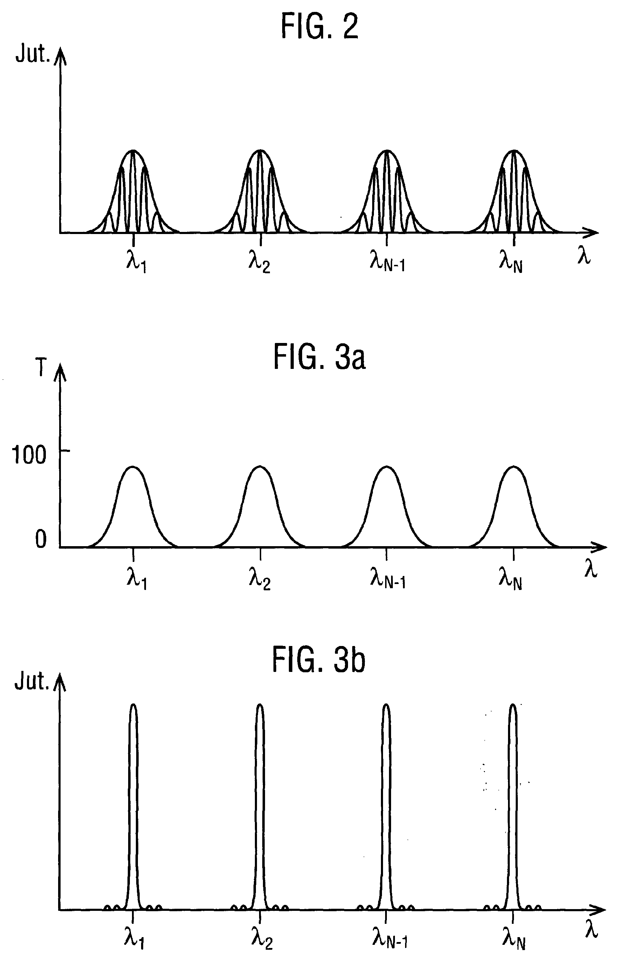

According to Fig. 1, a plurality of laser diodes $1_1$, $1_2$ to $1_N$ are used, according to the invention, in a manner combined in an optical arrangement, the said laser diodes respectively emitting an output spectra centred at a centre wavelength $\lambda_k$, k=1 to N. According to Fig. 2, the output spectra of the laser diodes $1_1$, $1_2$ to $1_N$ in [lacuna] each have a maximum intensity at the wavelength $\lambda_k$, k=1 to N. Further emission lines or modes adjoin the centre wavelength of maximum intensity on both sides in an approximately Gaussian distribution.

In the context of the invention, the respective output spectra of the laser diodes are preferably fed via optical fibres 2 into an optical multiplexer 3, whose broadband output signal is fed to a branching or beam splitting device 4 in a direction predetermined by the arrow $\vec{a}$ according to Fig. 1. The broadband output signal of the multiplexer 3 is an overall spectrum produced by superimposition of the output spectra of the individual laser diodes $1_1$, $1_2$ to $1_N$.

The beam-splitting device 4 preferably has a splitting ratio, with regard to the optical intensity, of 4% to 96%. The beams having different intensities emerge from two outputs 5, 6 of the beam splitting device 4, the partial beam with the intensity of 4% with regard to the overall intensity being directed in a fibre 7 in the direction of arrow $\vec{a}$ to a reflection unit 8, in order that it can be reflected back on itself. The reflection unit 8 is a mirror preferably formed by the vapour-deposition of metal, for instance using Ag or Au, on an end of the fibre 7, which mirror reflects virtually wavelength-independently in a spectral range which far exceeds the spectral range used according to the invention.

The beam that has now been reflected back runs along the arrow $\vec{b}$ in Fig. 1 through the output 5 back into the beam splitting device 4, and from there into the output of the multiplexer 3. The multiplexer 3 then acts like a demultiplexer on the broadband overall spectrum which enters at its output and has previously been reflected at the reflection unit 8. This is because the broadband overall spectrum is broken down in accordance with its individual output spectra respectively centred around the wavelengths $\lambda_k$, and locally directed back to the reflecting mirrors of the laser diodes $1_1$ to $1_N$ that previously emitted the corresponding output spectrum $\lambda_k$, k=1 to N in accordance with Fig. 1.

According to the invention, the transmission characteristic of the multiplexer 3 as illustrated in Fig. 3a is forced onto the output spectra in each case in the event of passage. According to the invention, the multiplexer 3 is chosen in such a way that it has passbands with approximately a maximum transmission of up to 100%, the said passbands being centred spectrally in each case at the centre wavelengths $\lambda_k$, k=1 to N of the output spectra of the laser diodes $1_1$ to $1_N$. The multiplexer 3 is preferably designed for superposing individual spectra or individual lines to form an overall spectrum, the passbands for the respective output spectra to be superposed preferably being Gaussian. Such a Gaussian passband may preferably have a full width half maximum of about 5 to 10 nm and a 3 dB bandwidth of about 3 nm.

According to the invention, upon each passage through the multiplexer 3, the respective output spectra $\lambda_k$, k=1 to N, is modified in accordance with the transmission characteristic. Mathematically the resulting spectral distribution can be described as convolution or multiplication of the respective output spectra of the laser diodes and of the spectral distribution of the respective passband.

The output spectra that have been modified in accordance with the transmission characteristic of the multiplexer 3 are then reflected by the reflecting mirrors of the laser diodes $1_1$, $1_2$ to $1_N$ in the direction of the arrow $\vec{a}$ fin the [sic] multiplexer 3. The modified output spectra that are then superposed in the multiplexer 3 are then once again split in the beam splitting device 4 and that part of the modified overall spectrum which has the weaker intensity is reflected.

In this case, after a certain transient behaviour, an external resonator is formed between the reflecting mirrors of the laser diodes $1_1$, $1_2$ to $1_N$ and the reflecting unit 8. It is essential to the invention here for the transmission characteristic of the multiplexer 3 to be forced onto the beams in each case in the event of passage thereof. As a result, the respect output spectra of the laser diodes $1_1$, $1_2$ to $1_N$ are coupled to, or stabilized at, the respective transmission maxima $\lambda_k$ of the passbands of the multiplexer 3.

According to the invention, the multiplexer 3 in the external resonator has the effect that, according to Fig. 3b, sidebands of the output spectra of the respective laser diodes $1_1$, $1_2$ to $1_N$ are distinctly suppressed in terms of intensity.

According to the invention, via the output 6 of the beam splitting device 4, the external resonator then emits the strongest part - with regard to the intensity - of the modified overall spectrum, at which the individual emission spectra emit stably and in a narrowband manner at a fixed wavelength according to Fig. 3b. According to the invention, the intensity respectively emitted by the laser diodes $1_1$, $1_2$ to $1_N$ falls in the event of emergence from the external resonator on the centre wavelength $\lambda_k$. A shift in the emission lines of maximum intensity to a different wavelength $\lambda_k$ plus $\Delta\lambda$ is remedied again, for instance in the case of one or in the case of all of the laser diodes, by the fixing of the optical resonance to the transmission maxima of the multiplexer.

As is illustrated in Fig. 4, instead of the splitting and beam splitting device, a junction at two media of differing optical density can also be effected and correspondingly split the beam. Thus, the invention provides for a junction 9 between glass, that is to say the fibre material, and for instance air to be provided in an optical fibre connected to the multiplexer 3 on the output side, at which junction corresponding separation into reflection and transmission is produced. In this case, transmission is considerably predominant in terms of intensity. The junction is preferably chosen in such a way that a reflection of about 4% which can be described according to Fresnel is achieved. The corresponding passages in transmission and in reflection through the multiplexer 3 correspond to those already described according to Fig. 1. In this embodiment, the laser resonator with external resonator is produced between the fibre/air junction, on the one hand, and the laser diodes $1_1$, $1_2$ to $1_N$, on the other hand.

The invention is not restricted to the exemplary embodiments described, which can be modified in many ways. Thus, for instance, the principle can be used, likewise in the manner described, by a single laser diode or a single laser. In this case, the output spectra of the laser is coupled to the wavelength which is selectively reflected by the reflection unit.

In the context of the invention, the multiplexer may be embodied as a Mach-Zehnder interferometer. In this case, the Mach-Zehnder interferometer may preferably be provided using fused technology (so-called fused interferometer) or be embodied in optical-integrated form, for instance using corresponding semiconductor materials such as silicon or indium phosphide. In this case, depending on the application and number of laser diodes, it is possible to use so-called 2 to 1 in the case of two laser diodes or 4 to 1 couplers in the case of four laser diodes. Moreover the Mach-Zehnder interferometers may be arranged in regular cascades. In a non-optical-integrated embodiment, a dielectric thin-film filter may also serve as a multiplexer.

Furthermore, in the context of the invention, provision is made, in an optical-integrated arrangement, for designing the multiplexer as a wave-guiding grating arrangement (array). In this case, corresponding interference which is necessary for the multiplexer or demultiplexer function is effected in a complex waveguide arrangement having preferably up to about one hundred waveguides. Such an arrangement corresponds, in a simplest approximation, to a traditional grating having one hundred slits.

According to the invention, the multiplexer must be adapted to the emission devices in terms of the transmission or pick-up characteristic in individual output spectra. The number of individual passbands that can be produced preferably interferometrically must be adapted to the number of emission devices, preferably laser diodes, used in the arrangement. If the number of laser diodes or of individual spectra that are to be transmitted is large, then it is understood that, according to the invention, the individual optical passbands are closely adjacent to one another. Under certain circumstances, the full width at half-maximum of the passbands must then be smaller. Thus, it is conceivable for an equidistant spacing of, for example, 200 gigahertz to be prescribed.

In the context of the invention, the beam splitting device 4 must be adapted to the two criteria mentioned below with regard to the splitting ratio of degree of transmission and degree of reflection. Firstly, a smaller reflection of about 1 to 2% only allows a low degree of stabilization or matching of the emission wavelength of the output spectra of the respective laser to a corresponding centre wavelength of the transmission characteristic of the multiplexer.

Secondly, a low reflection in the beam splitting device 4 leads to an increase in the output power of the resonator. If there is a need for a shift or coupling (locking) of the output wavelength of the respective laser by up to a few nanometers, then in the context of the invention, a beam splitting device 4 should be chosen which reflects the beam entering on the input side by at least about 4% and transmits it by at most about 96%.

The lasers used may, according to the invention, be Fabry-Perot lasers produced for example from compound semiconductors comprising gallium, arsenic, aluminium, phosphorus and antimony and the ternary and/or quaternary compounds thereof such as aluminium gallium indium phosphide (AlGaInP) or indium arsenic phosphide (InAsP). The preferred emission wavelengths are in the infrared region approximately between 1 000 and 1 700 nm.

According to the invention, the beam splitting device 4 may preferably be embodied using fused technology as a so-called fused fibre coupler. In this case, two fibres are fused together. However, any type of so-called monitor couplers are also conceivable using which in optical devices, so-called scanning or interrogation beams (pump and probe) can be branched off from a main beam path or can be introduced.

Finally, it is understood that the individual features of the invention can also be used in different combinations from the ones described and illustrated.

**Claims**

1. Method for wavelength stabilization of the light emission of at least two emission devices ($1_1$, $1_2$, $1_{N-1}$, $1_N$) by means of external optical resonator means, having the following steps:

superposition (3) of output spectra of the at least two emission devices to form an overall spectrum,
reflection ($\vec{b}$) of the overall spectrum at a reflection unit (8),
separation (3) of the reflected overall spectrum into the output spectra,
feeding ($\vec{b}$) of the reflected output spectra into the respective emissio n devices ($1_1$, $1_2$, $1_{N-1}$, $1_N$),
re-emission ($\vec{a}$) of the reflected output spectra from the emission devices ($1_1$, $1_2$, $1_{N-1}$, $1_N$),
mixing (3) of the re-emitted reflected emission spectra to form a modified overall spectrum, and
coupling (6) of the modified overall spectrum out of the resonator,

the reflection being effected at a wavelength-independent reflection unit (8).

2. Method according to Claim 1, **characterized in that** the overall spectrum is split (4) into two components, of which the first component is reflected and the second component is transmitted.

3. Method according to Claim 2, **characterized in that** the first, reflected component of the overall spectrum is separated by an optical mixing and demixing unit (3) in accordance with the output spectra.

4. Method according to Claim 3, **characterized in that** the separation of the first, reflected component in accordance with the output spectra is effected selectively with regard to respective transmission maxima of the mixing and demixing unit (3).

5. Method according to Claim 4, **characterized in that** the first, reflected component is small relative to the second transmitted component.

6. Arrangement for wavelength stabilization of an emission spectrum emitted by an emission device ($1_1$, $1_2$, $1_{N-1}$, $1_N$), comprising:

- at least one emission device ($1_1$, $1_2$, $1_{N-1}$, $1_N$)
- an optical resonator provided externally with respect to the at least one emission device ($1_1$, $1_2$, $1_{N-1}$, $1_N$),
- a beam splitting device (4), and
- an output device (6) for the emission spectrum,

the beam splitting device (4) being arranged in the beam path in such a way that the emission spectrum of the at least one emission device ($1_1$, $1_2$, $1_{N-1}$, $1_N$) traverses the beam splitting device (4) at least twice, and
the resonator being delimited by a reflection unit outside the at least one emission device ($1_1$, $1_2$, $1_{N-1}$, $1_N$).

7. Arrangement according to Claim 6, **characterized in that** the reflection unit is designed for wavelength-selective reflection of the emission spectrum and is provided in such a way that the emission spectrum reflected by it traverses the beam splitting device (4) at least twice.

8. Arrangement according to Claim 7, **characterized in that** the emission spectrum is stabilized in accordance with the wavelength selected by the reflection unit.

9. Arrangement according to Claim 6, **characterized in that** the arrangement comprises

   - at least two emission devices ($1_1$, $1_2$, $1_{N-1}$, $1_N$) and
   - an optical mixing and demixing unit (3),

   the mixing and demixing unit (3) being arranged in the beam path in such a way that the emission spectra of the at least two emission devices ($1_1$, $1_2$, $1_{N-1}$, $1_N$) traverse the unit (3) at least twice, and
   **in that** the resonator is delimited by a wavelength-independent reflection unit (8) outside the emission devices ($1_1$, $1_2$, $1_{N-1}$, $1_N$).

10. Arrangement according to Claim 9, **characterized in that** the optical mixing and demixing unit (3) has a predeterminable transmission characteristic.

11. Arrangement according to Claim 9 or 10, **characterized in that** the optical mixing and demixing unit (3) is designed for modifying the emission spectra.

12. Arrangement according to one of Claims 9 to 11, **characterized in that** the reflection unit (8) is a mirror.

13. Arrangement according to Claim 11, **characterized in that** the wavelength-independent reflection unit (9) is designed as an output device for the modified emission spectra.

14. Arrangement according to Claim 13, **characterized in that** the reflection unit (9) is a Fresnel reflection unit.

15. Arrangement according to one of Claims 6 to 14, **characterized in that** the arrangement contains optical fibres (2, 7).

16. Arrangement according to one of Claims 9 to 15, **characterized in that** the optical mixing and demixing unit (3) is designed as an optical multiplexer with a predeterminable transmission characteristic.

17. Arrangement according to Claim 16, **characterized in that** the multiplexer (3) is embodied as a Mach-Zehnder interferometer.

18. Arrangement according to Claim 16 or 17, **characterized in that** the multiplexer (3) is produced by means of fused technology in optical fibres.

19. Arrangement according to Claim 16, **characterized in that** the multiplexer (3) is a dielectric thin-film filter.

20. Arrangement according to one [lacuna] Claims 6 to 17, **characterized in that** the arrangement is designed as an integrated optical arrangement.

21. Arrangement according to one of Claims 13 to 20, **characterized in that** the reflection unit is designed as a glass/air junction (9).

22. Arrangement according to one of Claims 6 to 21, **characterized in that** the emission devices ($1_1$, $1_2$, $1_{N-1}$, $1_N$) are lasers.

23. Arrangement according to Claim 22, **characterized in that** the lasers ($1_1$, $1_2$, $1_{N-1}$, $1_N$) are designed as semiconductor lasers and/or semiconductor laser diodes.

24. Arrangement for wavelength fixing of emission spectra from lasers, comprising:

   - at least two lasers ($1_1$, $1_2$, $1_{N-1}$, $1_N$)
   - an optical resonator provided outside the at least two lasers ($1_1$, $1_2$, $1_{N-1}$, $1_N$),
   - an optical multiplexer (3)
   - a beam splitting device (4), and
   - an optical coupling-out unit (6),

   the beam splitting device (4) and the multiplexer (3) being arranged in the beam path in such a way that the emission spectra of the at least two lasers traverse the beam splitting device (4) and the multiplexer (3) at least twice,
   the resonator being formed by the multiplexer (3) and a wavelength-independent reflection unit (8) outside the lasers ($1_1$, $1_2$, $1_{N-1}$, $1_N$).

# FIG. 1

# FIG. 4

# FIG. 2

Jut.

$\lambda_1$  $\lambda_2$  $\lambda_{N-1}$  $\lambda_N$  $\lambda$

# FIG. 3a

T

100

0

$\lambda_1$  $\lambda_2$  $\lambda_{N-1}$  $\lambda_N$  $\lambda$

# FIG. 3b

Jut.

$\lambda_1$  $\lambda_2$  $\lambda_{N-1}$  $\lambda_N$  $\lambda$

**European Patent Office**

## EUROPEAN SEARCH REPORT

Application Number

EP 01 30 5278

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br>A | EP 1 006 628 A (PHOTONETICS)<br>7 June 2000 (2000-06-07)<br>* the whole document * | 1-13,16,<br>21-24<br>14-20 | H01S5/40 |
| A | WO 99 37002 A (NORTHERN TELECOM LTD<br>;EPWORTH RICHARD EDWARD (GB); KING<br>JONATHAN P) 22 July 1999 (1999-07-22)<br>* the whole document * | 1,6,<br>15-18 | |
| X | WO 94 06181 A (BELL COMMUNICATIONS RES)<br>17 March 1994 (1994-03-17)<br>* the whole document * | 1,6,20 | |
| A | US 5 773 345 A (OTA TAKESHI)<br>30 June 1998 (1998-06-30)<br>* figure 10 * | 1,6,24 | |
| A | PATENT ABSTRACTS OF JAPAN<br>vol. 009, no. 296 (P-407),<br>22 November 1985 (1985-11-22)<br>& JP 60 133407 A (HONDA GIKEN KOGYO<br>KK;OTHERS: 01), 16 July 1985 (1985-07-16)<br>* abstract * | 1,19 | TECHNICAL FIELDS SEARCHED (Int.Cl.7)<br><br>H01S |
| A | PATENT ABSTRACTS OF JAPAN<br>vol. 018, no. 340 (E-1569),<br>27 June 1994 (1994-06-27)<br>-& JP 06 085374 A (FUJI XEROX CO LTD),<br>25 March 1994 (1994-03-25)<br>* abstract * | 1,14 | |

The present search report has been drawn up for all claims

| Place of search | Date of completion of the search | Examiner |
|---|---|---|
| THE HAGUE | 8 February 2002 | Claessen, L |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 1 195 867 A1**

**ANNEX TO THE EUROPEAN SEARCH REPORT
ON EUROPEAN PATENT APPLICATION NO.**                    EP 01 30 5278

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2002

| Patent document cited in search report | | | Publication date | Patent family member(s) | | Publication date |
|---|---|---|---|---|---|---|
| EP | 1006628 | A | 07-06-2000 | FR | 2786937 A1 | 09-06-2000 |
| | | | | EP | 1006628 A1 | 07-06-2000 |
| | | | | JP | 2000174368 A | 23-06-2000 |
| WO | 9937002 | A | 22-07-1999 | WO | 9937002 A1 | 22-07-1999 |
| | | | | EP | 1070370 A1 | 24-01-2001 |
| WO | 9406181 | A | 17-03-1994 | US | 5351262 A | 27-09-1994 |
| | | | | CA | 2143944 A1 | 17-03-1994 |
| | | | | DE | 69329713 D1 | 04-01-2001 |
| | | | | DE | 69329713 T2 | 31-05-2001 |
| | | | | EP | 0663109 A1 | 19-07-1995 |
| | | | | JP | 2757235 B2 | 25-05-1998 |
| | | | | JP | 8501187 T | 06-02-1996 |
| | | | | WO | 9406181 A1 | 17-03-1994 |
| US | 5773345 | A | 30-06-1998 | JP | 2082092 C | 23-08-1996 |
| | | | | JP | 5014385 A | 22-01-1993 |
| | | | | JP | 8004271 B | 17-01-1996 |
| | | | | JP | 3169138 B2 | 21-05-2001 |
| | | | | JP | 5007055 A | 14-01-1993 |
| | | | | US | 5523879 A | 04-06-1996 |
| | | | | US | 5570226 A | 29-10-1996 |
| | | | | US | 5282257 A | 25-01-1994 |
| | | | | US | 5510920 A | 23-04-1996 |
| | | | | JP | 5198893 A | 06-08-1993 |
| JP | 60133407 | A | 16-07-1985 | JP | 1771142 C | 30-06-1993 |
| | | | | JP | 4064042 B | 13-10-1992 |
| JP | 06085374 | A | 25-03-1994 | JP | 3191998 B2 | 23-07-2001 |
| | | | | DE | 69328463 D1 | 31-05-2000 |
| | | | | DE | 69328463 T2 | 25-01-2001 |
| | | | | EP | 0590331 A2 | 06-04-1994 |
| | | | | US | 5915054 A | 22-06-1999 |
| | | | | US | 5854700 A | 29-12-1998 |
| | | | | US | 5684899 A | 04-11-1997 |

EPO FORM P0459

For more details about this annex : see Official Journal of the European Patent Office, No. 12/82

10